# EUROPÄISCHE PATENTSCHRIFT

(11) **EP 3 482 424 B1**
(45) Veröffentlichungstag und Bekanntmachung des Hinweises auf die Patenterteilung: **22.07.2020**
(21) Anmeldenummer: 16738388.4
(22) Anmeldetag: 07.07.2016
(51) Int. Cl.: H01L 41/04

(54) **VORRICHTUNG UND VERFAHREN ZUM ANSTEUERN EINER LAST SOWIE GERÄT**
DEVICE AND METHOD FOR ACTUATING A LOAD AND DEVICE
DISPOSITIF ET PROCÉDÉ POUR COMMANDER UNE CHARGE ET APPAREIL

(43) Veröffentlichungstag der Anmeldung: 15.05.2019
(73) Patentinhaber: Fraunhofer Gesellschaft zur Förderung der angewandten Forschung E.V., 80686 München (DE)
(72) Erfinder: VANSELOW, Frank, 85395 Attenkirchen (DE); KINZEL, Bernadette, 84416 Taufkirchen/Vils (DE); ISA, Erkan, 81475 München (DE)
(74) Vertreter: Hersina, Günter
(86) Internationale Anmeldenummer: PCT/EP2016/066134
(87) Internationale Veröffentlichungsnummer: WO 2018/006964

(56) Entgegenhaltungen:
- DE-A1-102012 208 756
- GB-A- 1 245 708

## Beschreibung

Die Erfindung bezieht sich auf eine Vorrichtung zum Ansteuern einer Last mit einem Ansteuersignal sowie auf ein entsprechendes Verfahren. Weiterhin bezieht sich die Erfindung auf ein Gerät, das insbesondere eine anzusteuernde Last aufweist.

Eine (elektronische) Last ist generell ein Bauteil, eine Baugruppe oder ein Gerät, das ein (elektrisches) Ansteuersignal empfängt. Ein Beispiel von Lasten sind Aktoren (oder Antriebselemente), die elektrische Ansteuersignale in mechanische Bewegung oder in andere physikalische Größen - z. B. Druck oder Temperatur - umwandeln und damit aktiv auf Prozesse oder Bauteile einwirken.

Besondere Aktoren sind beispielsweise Piezoaktoren, die mindestens ein piezoelektrisches Element aufweisen. Dabei wird ausgenutzt, dass manche Festkörper einen Zusammenhang zwischen einer Änderung einer elektrischen Polarisation - und somit dem Auftreten einer elektrischen Spannung am Festkörpern - und einer elastischen Verformung aufweisen. Gemäß einem weiteren Beispiel handelt es sich bei der Last um einen Teil eines Sensors, der durch das Ansteuersignal aktiviert wird oder dessen Messverhalten durch das Ansteuersignal beeinflusst wird.

Ein Anwendungsgebiet von Piezoaktoren sind Mikropumpen. Mikropumpen sind Pumpen zur Förderung von Flüssigkeiten, Gasen oder fließfähigen Stoffen, die mit den Methoden der Mikrosystemtechnik erzeugt worden sind. Die Piezoaktoren bewegen dabei - unter Verwendung des inversen Piezoeffekts - Membranen, um die Medien in bestimmte Richtungen zu fördern.

Für die Ansteuerung der Piezoaktoren wird in der Regel ein Wechselspannungssignal mit einer hohen positiven Amplitude (bis zu mehreren hundert Volt) und einer kleinen negativen Amplitude (bis zu -100 Volt) verwendet. Die Betragswerte der beiden Amplituden sind je nach Anwendung unterschiedlich und voneinander unabhängig, so dass sich ein asymmetrisches Ansteuersignal ergibt. Bei Mikropumpen sind die Amplituden z. B. in Abhängigkeit von der Dicke des piezoelektrischen Elements auf der Membran vorzugeben. Weiterhin ist beispielsweise bei Mikropumpen in gewissen - z. B. medizinischen - Anwendungen erforderlich, dass die mit dem Piezoaktor elektrisch verbundene Membran mit dem elektrischen Masse-Potential kontaktiert ist. Dadurch ist eine differentielle Ansteuerung des Piezoaktors nicht möglich, bei der die zwei Kontaktseiten des Piezoelements jeweils mit einer elektrischen Ansteuerschaltung verbunden sind.

Überdies ist es vorteilhaft, wenn die Elektronikkomponenten zur Ansteuerung der Mikropumpen möglichst kompakt und vorteilhafterweise weitgehend auf einem integrierten Schaltkreis (oder Integrated Circuit, IC) realisiert sind. Dies vereinfacht die Anwendung und Verwendung, z. B. in Mobiltelefonen oder medizinischen Geräten. Weiterhin lassen sich so Kosten reduzieren bzw. werden manche Anwendungen erst ermöglicht.

Unterschiedliche Konzepte zur Ansteuerung von Piezoaktoren sind beispielsweise beschrieben in der Dissertation mit Titel "Ansteuerkonzepte für piezoelektrische Aktoren" von Gunnar Gnad aus dem Jahr 2005.

Die DE 10 2012 208 756 A1 bezieht sich auf eine Schaltung, in der ein Injektor als Last von einer Gleichspannungsquelle mit einer Gleichspannung versorgt wird, um die Bewegung einer Nadel zu steuern. Zusätzlich ist eine Injektorzustandserfassungsvorrichtung vorhanden, die eine Wechselspannungsquelle und einen Kondensator aufweist und die die Last für die Erfassung des Zustands mit einer Wechselspannung beaufschlagt. Eine Steuerschaltung steuert über einen Stromschalter den Strom, der durch die Last fließt.

Die GB 1 245 708 A zeigt einen Wechselrichter zum Umwandeln einer Gleichspannung in eine Wechselspannung.

Die Aufgabe der Erfindung besteht daher darin, eine Ansteuerung einer Last vorzuschlagen, die eine Alternative zum Stand der Technik darstellt.

Die Erfindung löst die Aufgabe mit einer Vorrichtung zum Ansteuern einer Last, z. B. eines Piezoaktors. Die Vorrichtung ist derartig ausgestaltet, für die Ansteuerung der Last ein Ansteuersignal zu verwenden. Dieses Ansteuersignal wird dabei über einen Signalausgang ausgegeben. Dieser Signalausgang besteht in einer Ausgestaltung, in der die Vorrichtung und die Last kompakt und eng miteinander verbunden sind, aus einem Knoten, so dass es sich je nach Ausgestaltung bei dem Signalausgang um einen beliebigen Verbindungspunkt handeln kann. Ein Knoten ist dabei in der Schaltungstechnik ein Stromverzweigungspunkt eine elektrisch leitfähigen Verbindung von Komponenten.

Die Vorrichtung weist zumindest eine Wechselspannungsquelle, eine Gleichspannungsquelle, einen Kondensator und eine Steuervorrichtung auf.

Die Wechselspannungsquelle ist derartig ausgestaltet, eine Wechselspannung - vorzugsweise einer vorgebbaren Form in Bezug auf den Spannungsverlauf und/oder in Bezug auf den Betrag der Amplituden - auszugeben.

Die Gleichspannungsquelle ist derartig ausgestaltet, eine Gleichspannung mit einem vorgebbaren Betrag auszugeben.

Der Kondensator, der in einer Ausgestaltung aus einem Bauteil und in einer anderen Ausgestaltung aus mehreren zusammengeschalteten Kondensatorelementen oder aus Komponenten mit kapazitiven Eigenschaften besteht, weist einen ersten Anschluss und einen zweiten Anschluss auf.

Hierbei ist die Wechselspannungsquelle mit dem ersten Anschluss verbunden. Zudem ist der Signalausgang - und damit mittelbar auch die Last - mit dem zweiten Anschluss verbunden.

Schließlich ist die Steuervorrichtung derartig ausgestaltet, in Abhängigkeit von einer an dem Signalausgang anliegenden - elektrischen - Spannung eine Verbindung der Gleichspannungsquelle mit dem zweiten Anschluss zu steuern. Die Steuerung der Verbindung bedeutet dabei, dass die Steuervorrichtung im Wesentlichen als Schalter fungiert und abhängig von der anliegenden Spannung die Gleichspannungsquelle mit dem zweiten Anschluss verbindet oder eine solche Verbindung öffnet. Dabei ist die Gleichspannungsquelle in einer Ausgestaltung im verbundenen Zustand mit dem zweiten Anschluss des Kondensators, mit dem Signalausgang und mit der Last verbunden.

Durch die Gleichspannung ergibt sich eine Absenkung der Wechselspannung, so dass sich ein gewünschtes Ansteuersignal einstellt. Oder umgekehrt: das Ansteuersignal ergibt sich durch die Absenkung der Wechselspannung unter Verwendung der Gleichspannung.

Die Steuervorrichtung schaltet abhängig von der am Signalausgang und daher auch an der Last anliegenden Spannung die Gleichspannungsquelle hinzu oder fort. Damit wirkt sie auf der Seite des Kondensators, mit dem die anzusteuernde Last kontaktiert ist, spannungsbegrenzend.

In einer weiteren Ausgestaltung ergibt sich in Verbindung mit einem Umladen des Kondensators zudem eine Absenkung des Ansteuersignals in den negativen Spannungsbereich hinein. Dabei wird eine Differenz zwischen der Gleichspannung und der positiven Amplitude der Wechselspannung ausgenutzt.

Die Spannungsgrenze, bei der die Steuervorrichtung jeweils umschaltet, kann dabei durch eine externe Steuerung vorgegeben werden oder lässt sich in einer Ausgestaltung schaltungstechnisch vorgeben, indem die Steuervorrichtung die an dem Signalausgang anliegende Spannung mit der Gleichspannung der Gleichspannungsquelle vergleicht.

Daher besteht die Steuervorrichtung in einer Ausgestaltung aus einem Komparator und besteht die Steuervorrichtung in einer weiteren Ausgestaltung aus mindestens einem Gleichrichter. In einer abhängigen Ausgestaltung weist die Steuervorrichtung mindestens eine Diode auf.

In einer Ausgestaltung ist das Ansteuersignal ein Wechselspannungssignal mit einer positiven Amplituden und einer negativen Amplitude.

Dabei ist ein Betrag der positiven Amplitude des Ansteuersignals abhängig von dem Betrag der Gleichspannung der Gleichspannungsquelle. In einer Ausgestaltung ist der Betrag der positiven Amplitude im Wesentlichen gleich dem Betrag der Gleichspannung. Der Betrag der Gleichspannung ist dabei über die Gleichspannungsquelle vorgebbar, so dass die positive Amplitude des Ansteuersignals über die Gleichspannungsquelle in dieser Ausgestaltung vorgebbar ist. In dieser Ausgestaltung wird somit das Signal, das von der Wechselspannung abhängt, auf das Niveau der Gleichspannung abgesenkt.

Weiterhin ist in einer Ausgestaltung ein Betrag der negativen Amplitude des Ansteuersignals abhängig von einem Betrag einer Differenz zwischen einem Betrag einer positiven Amplitude der Wechselspannung der Wechselspannungsquelle und dem Betrag der Gleichspannung der Gleichspannungsquelle. In einer Ausgestaltung ist der Betrag der negativen Amplitude des Ansteuersignals im Wesentlichen gleich der besagten Differenz. Diese Differenz ist dabei ein Maß, um welches sich die Gleichspannung der Gleichspannungsquelle und die positive Amplitude der Wechselspannung der Wechselspannungsquelle voneinander unterscheiden. Die Differenz zwischen der positiven Amplitude der Wechselspannung und dem Betrag der Gleichspannung bedingt somit das Maß der Absenkung der Wechselspannung und damit auch die negative Amplitude des Anregungssignals.

Die Vorrichtung bewirkt insgesamt die Absenkung der erzeugten Wechselspannung um die Differenz zwischen der positiven Amplitude der Wechselspannung und dem Betrag der Gleichspannung.

In einer Ausgestaltung sind die Beträge der positiven Amplitude und der negativen Amplitude des Wechselspannungssignals unterschiedlich, so dass ein asymmetrisches Ansteuersignal vorliegt. Der Vorteil dieser Ausgestaltung ist, dass die Vorrichtung es erlaubt, ein Ansteuersignal (bzw. Wechselspannungssignal) mit betragsmäßig unterschiedlichen Amplituden zu erzeugen, wobei dies nicht differentiell erfolgt, sondern indem eine negative Amplitude generiert wird.

Alternativ ist ein symmetrisches Signal vorgesehen, bei dem die beiden Beträge gleich sind.

In einer Ausgestaltung ist vorgesehen, dass der Betrag der Gleichspannung der Gleichspannungsquelle kleiner ist als ein Betrag einer positiven Amplitude der Wechselspannung.

In einer Ausgestaltung ist die Steuervorrichtung derartig ausgeführt, die Gleichspannungsquelle in dem Fall mit dem zweiten Anschluss zu verbinden, dass die an dem Signalausgang anliegende Spannung größer als die Gleichspannung oder gleich der Gleichspannung der Gleichspannungsquelle ist. In diesem Fall findet an dem Signalausgang somit bedingt durch die Steuervorrichtung eine Spannungsbegrenzung statt. Damit geht einher, dass auf dieser Seite des Kondensators, auf der sich die Last bzw. der Signalausgang befindet, keine Spannung auftreten kann, die oberhalb der Gleichspannung der Gleichspannungsquelle liegt.

In einer Ausgestaltung weist die Wechselspannungsquelle eine steuerbare Stromquelle auf, die einen Wechselstrom erzeugt. Weiterhin ist die Stromquelle (oder genauer: die Wechselstromquelle) mit dem ersten Anschluss des Kondensators verbunden. In einer Ausgestaltung ist daher der Stromausgang der Stromquelle mit dem Ausgang der Wechselspannungsquelle verbunden und ist der Stromausgang der Stromquelle in einer weiteren Ausgestaltung der Ausgang der Wechselspannungsquelle.

In einer Ausgestaltung weist die Stromquelle mindestens zwei Stromregelschaltungen auf. In einer weiteren Ausgestaltung lassen sich die Stromregelschaltungen getrennt ansteuern. Ein Beispiel für eine Stromregelschaltung ist eine Stromspiegelschaltung. Dabei handelt es sich um Transistorschaltungen, mit denen von einem vorhandenen Referenzstrom ein weiterer Strom abgeleitet werden kann.

In einer weiteren Ausgestaltung weist die Wechselspannungsquelle einen Gleichspannungswandler auf. Dabei erzeugt der Gleichspanungswandler, der in einer Ausgestaltung als Aufwärtswandler ausgeführt ist, ausgehend von einer vorgegebenen Gleichspannung eine Ansteuerspannung, die in einer Ausgestaltung höher als die vorgegebene Gleichspannung ist. Diese Ansteuerspannung wird - insbesondere für ihre Steuerung - der Stromquelle zugeführt. Die Stromquelle erzeugt daher ein Stromsignal, das abhängig ist von der Ansteuerspannung. Damit entspricht auch die Spannung des Wechselstroms der Ansteuerspannung. Indem die Last somit über eine Stromquelle betrieben wird, lässt sich beispielsweise bei einem Aktor als Last ein zu erzeugende mechanische Hub - z. B. der einer Membran - besser kontrollieren.

In einer Ausgestaltung ist der Gleichspannungswandler als diskontinuierlich betriebener Aufwärtswandler ausgeführt. Ein Aufwärtswandler (andere Bezeichnungen sind Hochsetzsteller, Aufwärtsregler, Boost-Converter oder Step-Up-Converter) ist ein Gleichspannungswandler, wobei der Betrag der Ausgangsspannung größer als der Betrag der Eingangsspannung ist.

Gemäß einer Ausgestaltung ist die Stromquelle derartig ausgestaltet, eine Flankensteilheit der Wechselspannung der Wechselspannungsquelle einzustellen. Die Flankensteilheit - oder slew rate - bezeichnet dabei die Steilheit oder Steigung der Signalflanken eines Signals. In einer Ausgestaltung handelt es sich bei der Flankensteilheit insbesondere um die Steilheit der Flanken zwischen der positiven Amplitude der Wechselspannung der Wechselspannungsquelle und der unteren Amplitude mit 0 Volt. Es wird also der Übergang zwischen den Amplituden definiert.

In einer Ausgestaltung ist die Wechselspannungsquelle derartig ausgestaltet, dass die ausgegebene Wechselspannung frei von einer negativen Amplitude ist. In dieser Ausgestaltung verfügt die Wechselspannung der Wechselspannungsquelle somit nicht über negative Spannungswerte; die negativen Spannungswerte des Ansteuersignals werden erst durch die Absenkung über die Anwendung der Gleichspannung erzeugt. Daher ist ein Vorteil der Vorrichtung, dass aus einer unipolaren Wechselspannung eine bipolare Wechselspannung erzeugt wird.

In einer Ausgestaltung setzt sich daher die Vorrichtung zusammen aus einem ersten Teil, in dem nur positive Spannungen auftreten, und einem zweiten Teil, der die eigentliche Absenkung umfasst und in dem die negativen Spannungen des Ansteuersignals erzeugt werden. In einer damit einhergehenden Ausgestaltung ist der zweite Teil wegen der negativen Spannung von dem ersten Teil abgesetzt.

Gemäß einer Ausgestaltung ist die Wechselspannungsquelle derartig ausgestaltet, dass die ausgegebene Wechselspannung eine positive Amplitude und eine Amplitude mit 0 Volt aufweist. In dieser Ausgestaltung ist die Wechselspannung ebenfalls frei von einem negativen Spannungsanteil und wechselt zwischen einer positiven Amplitude und 0 Volt. Damit beträgt auch die kleinste Spannung dieser Wechselspannung 0 Volt.

In einer Ausgestaltung ist die Last mit Masse verbunden. Die Last ist somit einseitig geerdet. Dies kann z. B. in einer Ausgestaltung mit einem Piezoaktor als Last über eine Membran in einer Mikropumpe erfolgen. Dabei dient vorzugweise der Piezoaktor der Erzeugung der mechanischen Bewegungen der Membran und ist mit dieser auch elektrisch gekoppelt. Die einseitige Verbindung der Last mit Masse ist möglich, da die Vorrichtung zur Ansteuerung nicht differentiell arbeitet, sondern eine negative Spannung erzeugt.

In einer Ausgestaltung ist die Last durch eine kapazitive Eigenschaften gekennzeichnet. Damit geht in einer Ausgestaltung einher, dass die Kapazität des Kondensators größer ist als die Kapazität der Last. Die Verhältnisse der Kapazitäten sind in einer Ausgestaltung eins zu zehn und reichen in einer weiteren Ausgestaltung bis zu 1:100.

In einer Ausgestaltung weist die Vorrichtung ein Ladungspumpe auf. Eine Ladungspumpe (oder Charge Pump) ist eine elektrische Schaltung, die den Betrag einer elektrischen Spannung erhöht. Ladungspumpen kommen in der Regel zum Einsatz, wenn keine großen Ausgangströme erforderlich sind oder wenn keine geeigneten magnetischen Bauelemente wie z. B. Spulen eingesetzt werden können.

Gemäß einer Ausgestaltung weist die Steuervorrichtung mindestens einen Gleichrichter auf. In einer Ausgestaltung verfügt die Steuervorrichtung über mindestens eine Diode, die kathodenseitig mit der Gleichspannungsquelle und anodenseitig mit dem Signalausgang und darüber mittelbar mit dem zweiten Anschluss des Kondensators verbunden ist. Durch diese Anordnung senkt die Steuervorrichtung unter Verwendung der Gleichspannung der Gleichspannungsquelle das Signal ab, das am ersten Anschluss des Kondensators anliegt. Dies ist somit eine relativ einfache Ausgestaltung.

In einer Ausgestaltung ist die Steuervorrichtung als common-mode-Regelung realisiert. Bei einer - insbesondere linearen - common-mode-Regelung wird das Mittel zwischen zwei unterschiedlichen Ausgängen auf einen Referenzwert gesetzt, so dass es sich gleichsam um eine Pegelumsetzung handelt.

In einer Ausgestaltung der common-mode-Regelung besteht weiterhin eine Wechselspannungs-Kopplung zwischen der von der Wechselspannungsquelle erzeugten Wechselspannung und der Last bzw. dem Signalausgang. In einer Messschaltung - z. B. als Teil der Steuervorrichtung - wird ein Gleichspannungswert am Signalausgang, mit dem die Last verbunden ist, mit einem Vergleichswert verglichen, der der an der Last bzw. dem Signalausgang einzustellenden negativen Spannung entspricht. Über ein sich ergebendes Fehler- oder Abweichungssignal werden beispielsweise zwei Strom- oder Spannungsquellen gesteuert, die direkt mit dem Signalausgang verbunden sind.

Weiterhin löst die Erfindung die Aufgabe mit einem Gerät mit mindestens einer - anzusteuernden - Last und einer Vorrichtung zum Ansteuern der Last mit einem - über einen Signalausgang auszugebenden - Ansteuersignal. Die Vorrichtung weist eine Wechselspannungsquelle, eine Gleichspannungsquelle, einen Kondensator und eine Steuervorrichtung auf. Die Wechselspannungsquelle ist derartig ausgestaltet, eine Wechselspannung - vorzugsweise einer vorgebbaren Form - auszugeben. Die Gleichspannungsquelle ist derartig ausgestaltet, eine Gleichspannung mit einem vorgebbaren Betrag auszugeben. Der Kondensator weist einen ersten Anschluss und einen zweiten Anschluss auf, wobei die Wechselspannungsquelle mit dem ersten Anschluss und ein Signalausgang der Vorrichtung mit dem zweiten Anschluss verbunden ist. Schließlich ist die Steuervorrichtung derartig ausgestaltet, in Abhängigkeit von einer an dem Signalausgang anliegenden Spannung eine Verbindung der Gleichspannungsquelle mit dem zweiten Anschluss zu steuern. Die anzusteuernde Last ist dabei mit dem Signalausgang der Vorrichtung und daher auch mit dem zweiten Anschluss des Kondensators kontaktiert.

In einer weiteren Ausgestaltung ist die Vorrichtung des Geräts nach einer der obigen Ausgestaltungen ausgeführt. Daher gelten hier auch die obigen Ausführungen und Erläuterungen.

Gemäß einer Ausgestaltung handelt es sich bei der Last um einen Piezoaktor. Die Last beschreibt somit mindestens ein piezoelektrisches Element.

In einer Ausgestaltung handelt es sich bei dem Gerät um eine Mikropumpe.

Insgesamt gelten die obigen Erläuterungen und Ausgestaltungen bezüglich der Vorrichtung zum Ansteuern der Last auch für das Gerät, das eine solche Last umfasst. Daher sei hier auf eine Wiederholung verzichtet.

Alternativ findet die Vorrichtung beispielsweise Verwendung bei einem UltraschallWandler oder einem haptischen System oder einem Messgerät als Gerät.

Schließlich löst die Erfindung die Aufgabe durch ein Verfahren zur Ansteuerung einer Last mit einem Ansteuersignal.

Dabei ist die Last vorzugsweise mit einem Signalausgang zur Ausgabe des Ansteuersignals zu verbinden.

Dabei umfasst das Verfahren zumindest die folgenden Schritte:
- Es wird eine Wechselspannung - vorzugsweise mit einer vorgebbaren Form - erzeugt.
- Es wird eine Gleichspannung - vorzugsweise mit einem vorgebbaren Betrag - erzeugt.
- Ein erster Anschluss eines Kondensators wird mit der Wechselspannung beaufschlagt.
- Weiterhin wird ein zweiter Anschluss des Kondensators in Abhängigkeit von einer an einem Signalausgang anliegenden Spannung mit der Gleichspannung beaufschlagt.

Dabei ist der Signalausgang vorzugsweise mit dem zweiten Anschluss des Kondensators verbunden.

In Bezug auf das Verfahren gelten auch die obigen Ausgestaltungen und Ausführen bezüglich der Vorrichtung und umgekehrt. Das Verfahren kann insbesondere auch dazu verwendet werden, um eine Last eines Geräts anzusteuern.

Im Einzelnen gibt es eine Vielzahl von Möglichkeiten, die erfindungsgemäße Vorrichtung, das Gerät sowie das Verfahren auszugestalten und weiterzubilden. Dazu wird verwiesen einerseits auf die Patentansprüche, andererseits auf die folgende Beschreibung von Ausführungsbeispielen in Verbindung mit der Zeichnung. Es zeigen:
- Fig. 1: einen schematischen Aufbau einer erfindungsgemäßen Vorrichtung zum Ansteuern einer Last als Blockschaltbild in einer ersten Variante,
- Fig. 2: einen schematischen Aufbau einer zweiten Variante der erfindungsgemäßen Vorrichtung,
- Fig. 3: einen schematischen Verlauf von Signalen der Vorrichtung,
- Fig. 4: einen schematischen Aufbau einer dritten Variante der erfindungsgemäßen Vorrichtung in einer ersten Phase,
- Fig. 5: die Vorrichtung der Fig. 4 in einer zweiten Phase,
- Fig.6: eine detaillierte Darstellung einer weiteren Ausgestaltung einer Vorrichtung und
- Fig. 7: eine Mikropumpe als Gerät mit einer Vorrichtung zum Ansteuern eines Piezoaktors als Last.

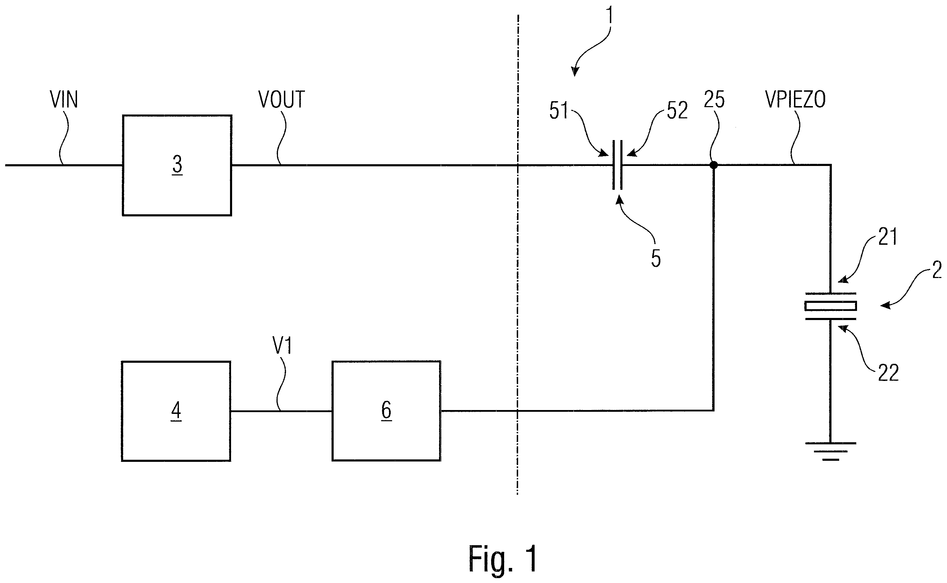

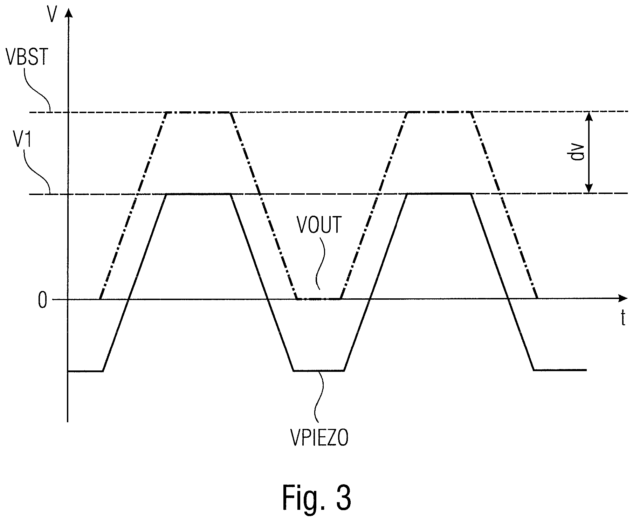

Die Fig. 1 zeigt einen schematischen Aufbau einer Ausgestaltung der erfindungsgemäßen Vorrichtung 1, die eine Last 2, die hier als Piezoaktor beispielhaft ausgeführt ist, mit einem Ansteuersignal VPIEZO ansteuert. Dabei ist das Ansteuersignal VPIEZO ein Wechselspannungssignal und verfügt über eine positive Amplitude und eine negative Amplitude. Die Amplituden mögen sich hier beispielhaft in Bezug auf ihre Beträge voneinander unterscheiden (siehe z. B. Fig. 3). Das Ansteuer- oder Wechselspannungssignal VPIEZO zur Ansteuerung der Last 2 ist daher asymmetrisch.

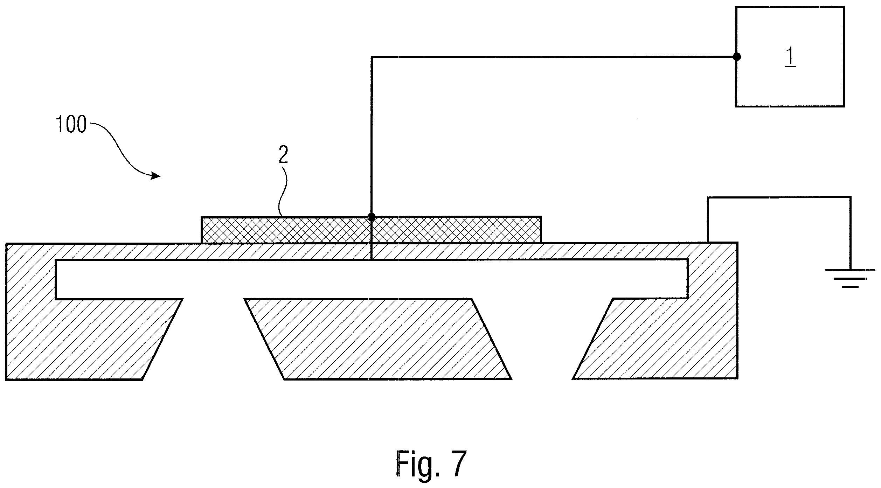

Die Last 2 ist mit einem ersten Kontakt 21 über einen Knoten als Signalausgang 25 mit der Vorrichtung 1 verbunden, um von der Vorrichtung 1 angesteuert zu werden. Weiterhin ist die Last 2 mit einem zweiten Kontakt 22 mit Masse verbunden. Der zweite Kontakt 22 ist in der Anwendung beispielsweise die Seite, die mit einem zu bewegenden Objekt, z. B. einer Membran mechanisch gekoppelt ist (siehe z. B. Fig. 7).

Die Vorrichtung 1 verfügt über eine Wechselspannungsquelle 3, die in dem gezeigten Beispiel aus einer Gleichspannung VIN, die beispielsweise von einer Batterie stammt, eine Wechselspannung VOUT erzeugt. Dafür weist die Wechselspannungsquelle 3 beispielsweise einen induktiven asynchronen Aufwärtswandler auf, der diskontinuierlich betrieben wird.

Die sich ergebende Wechselspannung VOUT weist in dem gezeigten Beispiel eine positive Amplitude mit dem Betrag VBST, der größer als der Betrag der Eingangsspannung VIN ist, und weist eine Amplitude auf, die Null Volt beträgt. Die Wechselspannung VOUT ist damit frei von einem negativen Anteil, d. h. es treten keine negativen Spannungen auf. Die Eingangsspannung VIN betrage beispielsweise 5 V und die positive Amplitude VBST 100 V.

Die Wechselspannungsquelle 3 ist mit einem ersten Anschluss 51 - also mit einer ersten Seite - des Kondensators 5 verbunden, so dass diese Seite des Kondensators 5 mit der Wechselspannung VOUT beaufschlagt wird.

Zudem verfügt die Vorrichtung 1 über eine Gleichspannungsquelle 4, die eine Gleichspannung mit Betrag V1 ausgibt. Diese Gleichspannung V1 wird über eine Steuervorrichtung 6 mit dem zweiten Anschluss 52 des Kondensators 5 verbunden. Dabei ist der Betrag der Gleichspannung V1 vorzugsweise kleiner als der Betrag der positiven oder oberen Amplitude der Wechselspannung VOUT. Es gilt also vorzugweise |V1| < |VBST|. Für die obigen Beispielswerte sei V1 gleich 70 V.

Die Steuervorrichtung 6 verbindet die Gleichspannungsquelle 4 mit dem Signalausgang, d. h. hier dem Knoten 25 und damit über den zweiten Anschluss 52 mit der zweiten Seite des Kondensators 5 in Abhängigkeit von einer Spannung, die an dem Signalausgang 25 und daher auch an der Last 2 anliegt.

Übersteigt in einer Ausgestaltung eine positive Spannung am Signalausgang 25 den Betrag der Gleichspannung, so wird die Gleichspannungsquelle 4 mit dem zweiten Anschluss 52 des Kondensators 5 verbunden. Dadurch lädt sich der Kondensator 5 bei einer höheren positiven Spannung der Wechselspannungsquelle 3 auf die Differenz zwischen dem Betrag der positiven Amplitude der Wechselspannung VOUT und dem - in diesem Beispiel kleineren - Betrag der - in diesem Fall ebenfalls positiven - Gleichspannung V1 auf. Diese Spannungsdifferenz dV, die hier gegeben ist durch dV = VBST - V1, ist im Fall des Umladens des Kondensators 5 der Betrag, um den die Wechselspannung VOUT herabgesetzt wird, um das Ansteuersignal VPIEZO zu erzeugen.

Fällt die Spannung am Knoten 25 wieder ab, so öffnet die gleichsam als Schalter dienende Steuervorrichtung 6 die Verbindung zwischen Gleichspannungsquelle 4 und dem Knoten 25 bzw. dem zweiten Anschluss 52 des Kondensators 5.

Somit liegt an einer Seite des Kondensators 5 eine Wechselspannung VOUT und an einer anderen Seite zumindest zeitweise eine Gleichspannung V1 an. Dies führt zum Absenken der Wechselspannung VOUT um den Betrag der Gleichspannung V1. Dies führt auch dazu, dass die Amplitude einer beispielhaften Wechselspannung VOUT mit 0 Volt eine negative Spannung ergibt, mit der die Last 2 beaufschlagt wird. Für das Beispiel beträgt daher die negative Spannung -30 V, da dV = VBST - V1 = 100 - 70. Damit ergibt sich insgesamt das Wechselspannungssignal VPIEZO mit den betragsmäßig unterschiedlichen Amplituden.

Die strich-punktierte Linie trennt hier die Bereiche der Vorrichtung 1, die nur positive Spannungen (hier linke Seite) und die positive und negative Spannungen (rechte Seite) aufweisen. Diese Trennung in Bezug auf die Eigenschaften wird in einer Ausgestaltung ausgenutzt, um die Vorrichtung 1 in zwei Bereiche oder Teile aufzuteilen.

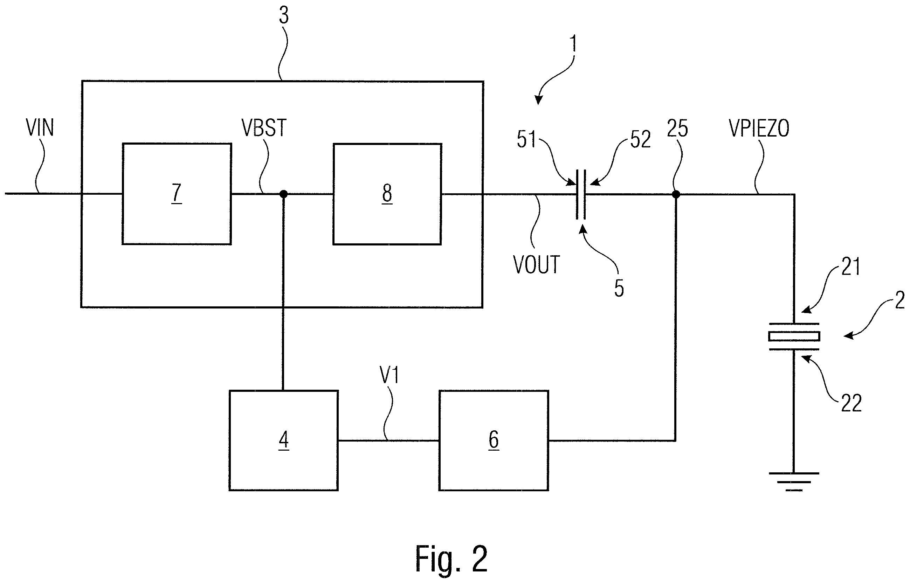

Die Fig. 2 zeigt eine weitere Ausgestaltung der Vorrichtung 1. Der Aufbau ist prinzipiell ähnlich dem der Vorrichtung der Fig. 1. Zwei Unterschiede bestehen in der Ausgestaltung der Wechselspannungsquelle 3 sowie darin, dass es eine Verbindung zwischen der Wechselspannungsquelle 3 und der Gleichspannungsquelle 4 gibt. Diese beiden Unterschiede werden im Folgenden erläutert. Für die restliche Schaltung sei auf die Ausführungen zur Fig. 1 verwiesen.

Die Wechselspannungsquelle 3 verfügt hier über einen Gleichspannungswandler 7, bei dem es sich beispielsweise um einen Aufwärtswandler handelt. Ein solcher DC-DC-Wandler 7 erzeugt aus einer Eingangsspannung VIN eine höhere Ansteuerspannung VBST. Diese Ansteuer(wechsel)spannung VBST wird einer Stromquelle 8 zugeführt, die ein Wechselstromsignal erzeugt. Damit ergibt sich am Ausgang der Wechselspannungsquelle 3 und damit auch am ersten Anschluss 51 des Kondensators 5 die Wechselspannung VOUT.

Weiterhin gelangt die Ansteuerspannung VBST auch zu der Gleichspannungsquelle 4. Dadurch wird beispielsweise eine zusätzliche, z. B. externe Spannungs- und Energiequelle eingespart.

In der Fig. 3 sind die Verläufe von mehreren Signale der Vorrichtung der Fig. 2 schematisch aufgetragen. Dabei ist auf der Y-Achse die Spannung (V) und auf der X-Achse die Zeit (t) aufgetragen.

Eingetragen sind die Ansteuerspannung VBST des Gleichspannungswandlers 7 sowie die Gleichspannung V1 der Gleichspannungsquelle 4. Beide Gleichspannungen VBST und V1 sind größer als Null.

VBST ist weiterhin der Betrag der oberen Amplitude der Wechselspannung VOUT, die zum einen diese obere Amplitude VBST und zum anderen die untere Amplitude mit 0 V aufweist. Die Stromquelle 8 erlaubt dabei die Einstellung der Steilheit der Flanken dieses Wechselspannungssignals VOUT.

V1 wiederum ist der Betrag der Gleichspannung, mit der das Ausgangssignal VOUT abgesenkt wird. Zwischen den Werten VBST und V1 besteht die Differenz dV = VBST - V1. Dabei ist der Betrag der oberen Amplitude der Wechselspannung VOUT größer als der Betrag der Gleichspannung V1.

Durch die Absenkung ergibt sich das Wechselspannungssignal VPIEZO, das über den Signalausgang 25 der Last 2 zugeführt wird. Das Wechselspannungssignal VPIEZO hat eine positive Amplitude, die dem Betrag der Gleichspannung V1 entspricht. Zudem hat das Wechselspannungssignal VPIEZO eine negative Amplitude, die im gezeigten Beispiel gleich der Differenz zwischen VBST und V1 ist.

Ausgehend von den Signalverläufen der Fig. 3 können daher die Ausgestaltungen der Fig. 1 und 2 derartig verstanden werden, dass bis zum ersten Kontakt 51 des Kondensators 5 keine negativen Spannungen auftreten und dass diese erst über den Kondensator 5 hinweg durch die Absenkung um die Differenz zwischen den Spannungen dV = VBST - V1 erzeugt wird.

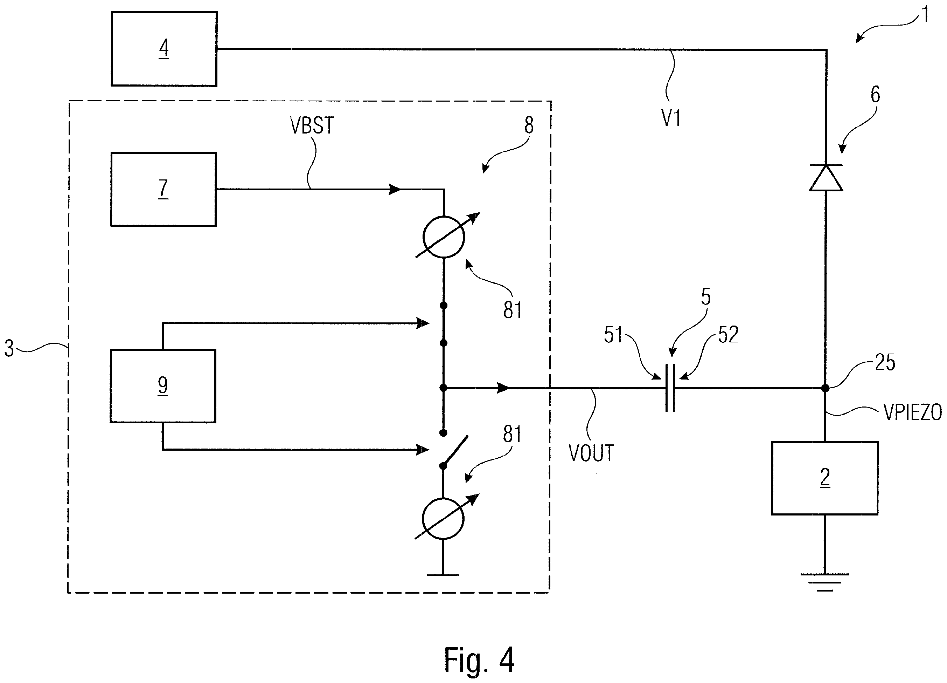

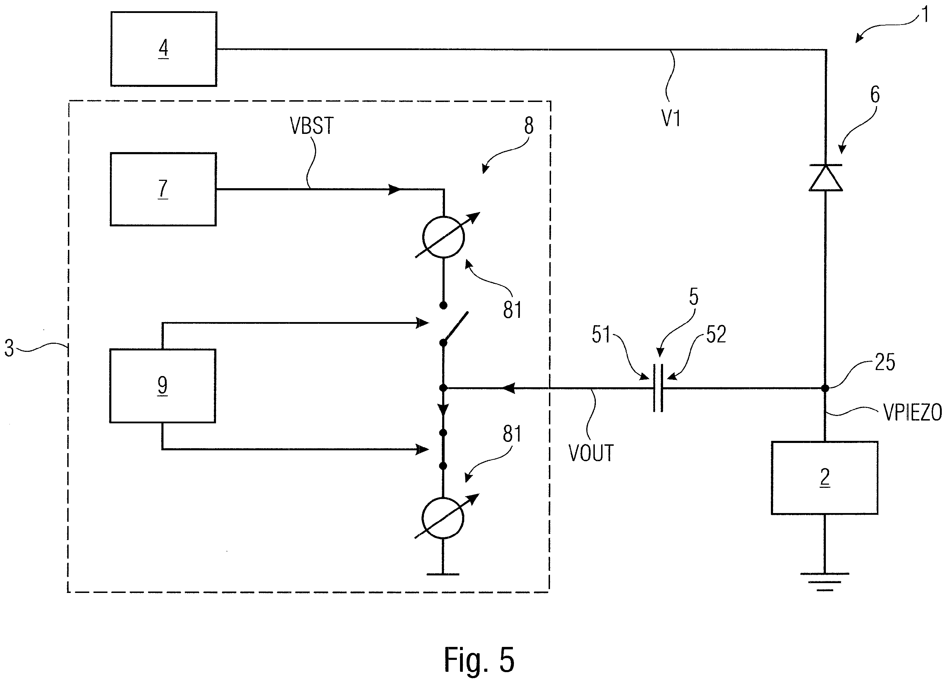

Das Funktionieren der Vorrichtung 1 wird an einer weiteren Ausgestaltungen mit den Abbildungen Fig. 4 und Fig. 5 erläutert, die sich jeweils auf unterschiedliche Phasen beziehen.

Die in beiden Abbildungen Fig. 4 und 5 dargestellte Vorrichtung 1 ist über einen Knoten 25 als Signalausgang jeweils mit einer Last 2 verbunden, die zusätzlich noch mit Masse kontaktiert ist. Die Last 2 wird somit nicht differentiell angesteuert, sondern die Vorrichtung 1 stellt ein Ansteuersignal VPIEZO in Form einer Wechselspannung mit positiver und negativer Amplitude zur Verfügung.

Die Vorrichtung 1 verfügt über eine Gleichspannungsquelle 4, die eine Gleichspannung mit dem hier positiven Betrag V1 erzeugt. Weiterhin weist die Vorrichtung 1 eine Wechselspannungsquelle 3 auf, die ein Wechselspannungssignal VOUT mit zwei Amplituden ausgibt. Zudem sind der Vorrichtung 1 noch eine Steuervorrichtung 6 und ein Kondensator 5 zugeordnet.

Die von der Wechselspannungsvorrichtung 3 erzeugte Wechselspannung VOUT wird auf eine Seite 51 des Kondensators 5 gegeben. Die Gleichspannung V1 der Gleichspannungsquelle 4 gelangt über die Steuervorrichtung 6, die gleichsam als spannungsgesteuerter Schalter dient, an die andere Seite 52 des Kondensators 5. Mit der Seite 52 des Kondensators 5, die mit der Gleichspannung V1 beaufschlagt wird, ist auch die elektrische Last 2 verbunden, um das Ansteuersignal VPIEZO zu erhalten. Die Last 2 und die Gleichspannungsquelle 4 sind dabei über den gleichen Knoten 25, der hier auch als Signalausgang fungiert, mit dem zweiten Anschluss 52 verbunden. Dies können jedoch auch zwei unterschiedliche physikalische Knoten bzw. Anschlüsse sein.

Die Steuervorrichtung 6 ist hier als Diode - als ein Beispiel für einen Gleichrichter - ausgeführt, die sperrt, wenn die Spannung am Knoten 25 und damit auch an der Last 2 unterhalb der Gleichspannung V1 der Gleichspannungsquelle 4 liegt. Im gesperrten Zustand der Diode 6 ist somit der Schalter in Form der Steuervorrichtung 6 geöffnet.

Ist die Spannung am Knoten 25 im Wesentlichen gleich der Gleichspannung V1 oder größer als die Gleichspannung V1, so ist der Schalter 6 geschlossen und die Gleichspannungsquelle 4 ist mit dem zweiten Anschluss 52 des Kondensators 5 verbunden.

Die Wechselspannungsquelle 3 verfügt über einen Gleichspannungswandler 7, der als Spannungsquelle für eine Ansteuerspannung VBST dient. Die Ausgestaltung als Gleichspannungswandler bzw. insbesondere als Aufwärtswandler hat den Vorteil, dass eine deutlich kleinere Eingangsspannung, die z. B. von einer Batterie geliefert wird, ausreichend ist.

Diese Ansteuerspannung VBST wird einer Stromquelle 8 zugeführt, die hier über zwei Stromregelschaltungen 81 verfügt. Die Stromregelschaltungen 81 stellen gleichsam einzeln regelbare Stromquellen da. Beide Stromregelschaltungen 81 verfügen jeweils über einen Schalter, mit dem sie mit einem Knoten verbunden sind, der zum Signalausgang der Wechselspannungsquelle 3 und damit zum ersten Anschluss 51 des Kondensators 5 führt. Die hier zeichnerisch obere Stromregelschaltung 81 ist mit dem Gleichspannungswandler 7 und dem Ausgangsknoten verbunden. Die andere Stromregelschaltung 81 ist einerseits mit Masse und anderseits mit dem Ausgangsknoten kontaktiert.

Auf die beiden Schalter der Stromquelle 8 wirkt eine Steuerung 9 ein, die beide Schalter abwechselnd öffnet und schließt. Durch diesen Wechsel ergibt sich dann eine Wechselspannung, die am Kondensator 5 die Wechselspannung VOUT bewirkt.

In der in der Fig. 4 gezeigten Phase ist der obere Schalter geschlossen und ist der untere Schalter geöffnet, so dass der Gleichspannungswandler 7 über die obere Stromregelschaltung 81 mit dem ersten Anschluss 51 des Kondensators 5 kontaktiert ist. Für den Stromfluss sind zur Verdeutlichung zwei Pfeile auf den Leitungen aufgetragen.

In dieser Phase wird somit der Kondensator 5 aufgeladen. Auf der anderen Seite des Kondensators 5 reagiert die Steuervorrichtung 6 erst in dem Augenblick, in dem der Wert der Gleichspannung V1 der Gleichspannungsquelle 4 erreicht wird. In diesem Augenblick verbindet die Steuervorrichtung 6 die Gleichspannungsquelle 4 mit dem Knoten 25 und damit mit dem zweiten Anschluss 52 des Kondensators 5.

Da der Betrag der Ansteuerspannung VBST des Gleichspannungswandlers 7 größer ist als der Betrag der Gleichspannung V1, ergibt sich eine Spannung dV am Kondensator 5, die gleich der Differenz zwischen der Ansteuerspannung VBST und der Gleichspannung V1 ist. Dabei seien Verlusteffekte vernachlässigt.

Die Last 2 wiederum wird mit einem Ansteuersignal VPIEZO beaufschlagt, das in dieser Phase eine Amplitude hat, die gleich der Gleichspannung V1 der Gleichspannungsquelle 4 ist. Daher ist also für die Phase, in der die positiven Anteile des Ansteuersignals VPIEZO erzeugt werden, eine Spannungsbegrenzung gegeben.

In der nächsten Phase, die die Fig. 5 zeigt, ist der obere Schalter der Stromquelle 8 geöffnet und ist der untere geschlossen. In diesem Fall ist der Gleichspannungswandler 7 abgekoppelt und der Strom fließt vom Kondensator 5 über die untere Stromregelschaltung 81 gegen Masse. Dies ist wieder durch zwei Pfeile auf den Leitungen angedeutet.

Über den Kondensator 5 fällt weiterhin die Differenzspannung dV ab. Insofern die Differenzspannung dV kleiner als die Gleichspannung V1 der Gleichspannungsquelle 4 ist, öffnet die Steuervorrichtung 6, so dass am Knoten 25 und damit auch an der Last 2 gerade diese Differenzspannung dV als negative Spannung anliegt.

Damit wird der Last 2 ein Ansteuersignal VPIEZO zugeführt, das eine negative Amplitude aufweist, wobei bei den meisten Komponenten der Vorrichtung 1 nur positive Spannungen auftreten.

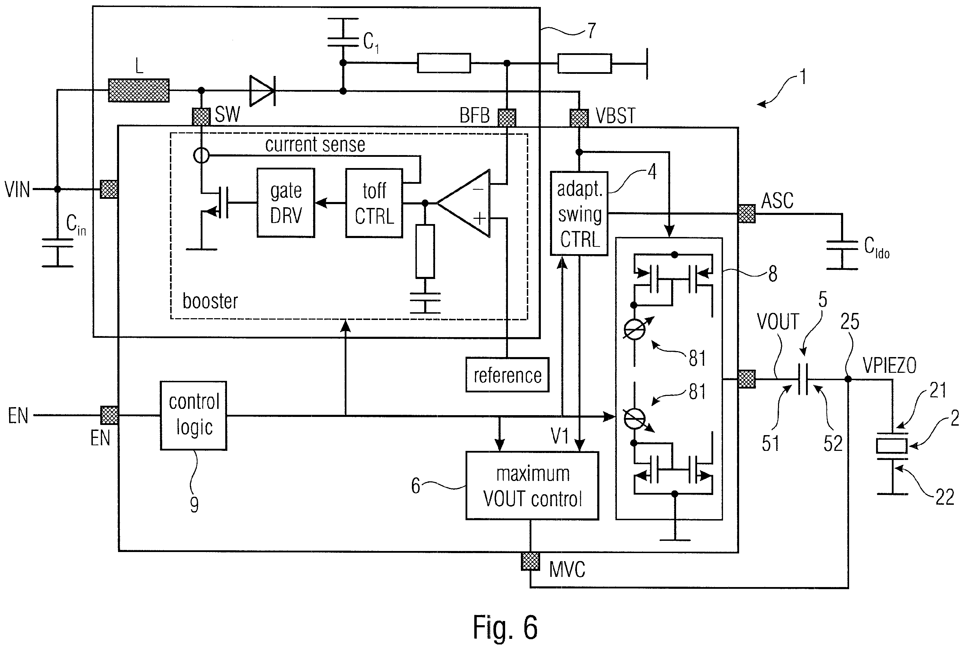

In der Fig. 6 ist die Vorrichtung 1 gemäß einer weiteren Ausgestaltung detaillierter dargestellt. Dabei lässt sich auch sehr gut die angesprochene Trennung in die zwei Bereiche erkennen.

Der Gleichspannungswandler 7 ist teilweise in einem IC integriert und weist ein paar separate Komponenten auf, die z. B. wegen ihrer Dimensionierungen zu groß für eine Integration sind. Dazu gehört z. B. die mit L bezeichnete Spule, eine Diode und ein paar Kapazitäten nebst Widerständen.

Der Gleichspannungswandler 7 wird - über den ebenso benannten Eingang - mit der Eingangsspannung VIN beaufschlagt und generiert die Ansteuerspannung VBST. Zudem ist noch eine Einheit (bezeichnet mit Reference) vorgesehen, die einen Referenzwert zur Steuerung des Gleichspannungswandlers 7 liefert.

Zusätzlich wird über eine Steuerung 9 ausgehend von einem mit EN bezeichneten Eingang regelnd auf den Gleichspannungswandler 7 eingegriffen, um z. B. den Betrag der positiven Amplitude der zu erzeugenden Ansteuerspannung VBST vorzugeben.

Die Ansteuerspannung VBST wird der Gleichspannungsquelle 4 sowie der steuerbaren Stromquelle 8 zugeführt.

Die Gleichspannungsquelle 4 ist hier auch als "Adaptive Swing Control" bezeichnet. Auf die Gleichspannungsquelle 4 ist dabei über die Steuerung 9 ebenfalls ein Eingriff, insbesondere in Bezug auf den Betrag der zu erzeugenden Gleichspannung V1 möglich. Die Gleichspannungsquelle 4 erzeugt die Gleichspannung mit dem Betrag V1, die der hier auch als "Maximum Vout Control" bezeichnenden Steuervorrichtung 6 zugeführt wird. Weiterhin ist die Gleichspannungsquelle 4 über einen ASC-Ausgang des IC mit einem externen Kondensator kontaktiert.

Über die Steuervorrichtung (eine alternative Bezeichnung wäre generell: spannungsabhängige Schaltvorrichtung) 6, auf die ebenfalls die Steuerung 9 einwirkt, und über einen mit MVC bezeichneten Ausgang wird die Gleichspannung V1 einem Knoten als Signalausgang 25 zugeführt. Der Knoten 25 ist mit dem zweiten Kontakt 52 des Kondensators 5 und mit dem ersten Kontakt 21 der hier als Piezoaktor ausgeführten Last 2 verbunden. Der zweite Kontakt 22 der Last 2 ist auch hier mit Masse verbunden.

Die Gleichspannung V1 erlaubt über den Kondensator 5 die Absenkung der Wechselspannung VOUT, die am ersten Kontakt 51 des Kondensators 5 anliegt. Das Ausgangssignal VOUT wird von der Stromquelle 8 ausgehend von der Ansteuerspannung VBST erzeugt.

Die Stromquelle 8 verfügt hier über zwei Stromspiegel als konkrete Ausgestaltungen der Stromregelschaltungen 81. Dabei handelt es sich um Transistorschaltungen, mit denen von einem vorhandenen Referenzstrom ein weiterer Strom abgeleitet werden kann. Die Stromquelle 8 erzeugt entsprechend das Ausgangssignal VOUT, das hier über einen Ausgang des IC ausgegeben wird.

Die separate Steuerung - hier vermittelt durch die Steuerung 9 bzw. die Schnittstelle EN des IC - der Gleichspannungsquelle 4 und der Wechselspannungsquelle 3 oder mindestens einer Komponente 7, 8 erlaubt die separate Einstellung der beiden jeweils zu erzeugenden Spannungen VBST und V1 und damit auch die Form des Wechselspannungssignals als Ansteuersignals VPIEZO zur Ansteuerung der Last 2.

Die Fig. 7 zeigt eine Mikropumpe als ein Beispiel für ein Gerät 100, die über eine Membran verfügt, an die eine Kavität angrenzt. Zum Fördern eines - hier nicht dargestellten - Mediums ist auf der Membran ein Piezoaktor als Last 2 aufgebracht, dessen mechanische Bewegungen auf die Membran übertragen werden. Die Ansteuerung des Piezoaktors 2 mit dem oben beschriebenen Wechselspannungssignal als Ansteuersignal erfolgt durch die Vorrichtung 1. Daher gelten auch hier die obigen Ausführungen.

Die Membran ist hier weiterhin elektrisch mit der ihr zugewandten Seite des Piezoaktors 2 verbunden und ist elektrisch mit Masse kontaktiert, so dass auch der Piezoaktor 2 mit einer Seite mit Masse verbunden ist.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Die Forschungsarbeiten, die zu diesen Ergebnissen geführt haben, wurden von der Europäischen Union gefördert.

## Patentansprüche

1. Vorrichtung (1) zum Ansteuern einer Last (2) mit einem Ansteuersignal (VPIEZO), wobei die Vorrichtung (1) eine Wechselspannungsquelle (3), eine Gleichspannungsquelle (4), einen Kondensator (5) und eine Steuervorrichtung (6) aufweist, wobei die Wechselspannungsquelle (3) derartig ausgestaltet ist, eine Wechselspannung (VOUT) auszugeben,
wobei die Gleichspannungsquelle (4) derartig ausgestaltet ist, eine Gleichspannung (V1) mit einem vorgebbaren Betrag auszugeben,
wobei der Kondensator (5) einen ersten Anschluss (51) und einen zweiten Anschluss (52) aufweist,
wobei die Wechselspannungsquelle (3) mit dem ersten Anschluss (51) verbunden ist,
wobei die Wechselspannungsquelle (3) derartig ausgestaltet ist, dass die ausgegebene Wechselspannung (VOUT) frei von einer negativen Amplitude ist,
wobei ein Signalausgang (25) mit dem zweiten Anschluss (52) verbunden ist, dadurch charakterisiert, dass die Steuervorrichtung (6) derartig ausgestaltet ist, in Abhängigkeit von einer an dem Signalausgang (25) anliegenden Spannung eine Verbindung der Gleichspannungsquelle (4) mit dem zweiten Anschluss (52) zu steuern,
wobei die Steuervorrichtung (6) derartig ausgestaltet ist, die Gleichspannungsquelle (4) mit dem zweiten Anschluss (52) zu verbinden, wenn die an dem Signalausgang (25) anliegende Spannung größer oder gleich der Gleichspannung (V1) der Gleichspannungsquelle (4) ist,
wobei das Ansteuersignal (VPIEZO) ein Wechselspannungssignal mit einer positiven Amplitude und einer negativen Amplitude ist,
wobei ein Betrag der positiven Amplitude des Ansteuersignals (VPIEZO) abhängig von dem Betrag der Gleichspannung (V1) der Gleichspannungsquelle (4) ist, und wobei ein Betrag der negativen Amplitude des Ansteuersignals (VPIEZO) abhängig ist von einem Betrag einer Differenz zwischen einem Betrag einer positiven Amplitude der Wechselspannung (VOUT) der Wechselspannungsquelle (3) und dem Betrag der Gleichspannung (V1) der Gleichspannungsquelle (4).

2. Vorrichtung (1) nach Anspruch 1,
wobei der Betrag der Gleichspannung (V1) der Gleichspannungsquelle (4) kleiner ist als ein Betrag einer positiven Amplitude der Wechselspannung (VOUT) der Wechselspannungsquelle (3).

3. Vorrichtung (1) nach Anspruch 1 oder 2,
wobei die Wechselspannungsquelle (3) eine steuerbare Stromquelle (8) aufweist, wobei die Stromquelle (8) derartig ausgestaltet ist, einen Wechselstrom zu erzeugen, und
wobei die Stromquelle (8) mit dem ersten Anschluss (51) des Kondensators (5) verbunden ist.

4. Vorrichtung (1) nach Anspruch 3,
wobei die Stromquelle (8) mindestens zwei Stromregelschaltungen (81) aufweist.

5. Vorrichtung (1) nach Anspruch 3 oder 4,
wobei die Wechselspannungsquelle (3) einen Gleichspannungswandler (7) aufweist,
wobei der Gleichspannungswandler (7) derartig ausgestaltet ist, ausgehend von einer Gleichspannung (VIN) eine Ansteuerspannung (VBST) zu erzeugen, und wobei die von dem Aufwärtswandler (7) erzeugte Ansteuerspannung (VBST) der Stromquelle (8) zugeführt ist.

6. Vorrichtung (1) nach einem der Ansprüche 1 bis 5,
wobei die Wechselspannungsquelle (3) derartig ausgestaltet ist, dass die ausgegebene Wechselspannung (VOUT) eine positive Amplitude und eine Amplitude mit 0 Volt aufweist.

7. Vorrichtung (1) nach einem der Ansprüche 1 bis 6,
wobei die Last (2) mit Masse verbunden ist.

8. Vorrichtung (1) nach einem der Ansprüche 1 bis 7,
wobei die Steuervorrichtung (6) mindestens einen Gleichrichter aufweist.

9. Vorrichtung (1) nach einem der Ansprüche 1 bis 8,
wobei die Steuervorrichtung (6) mindestens eine Diode aufweist, die kathodenseitig mit der Gleichspannungsquelle (4) und anodenseitig mit dem Signalausgang (25) verbunden ist.

10. Gerät (100) mit mindestens einer Last (2) und einer Vorrichtung (1) gemäß einem der vorhergehenden Ansprüche.

11. Gerät (100) nach Anspruch 10,
wobei die Vorrichtung (1) nach einem der Ansprüche 2 bis 9 ausgestaltet ist.

12. Gerät (100) nach Anspruch 10 oder 11,
wobei es sich bei der Last (2) um einen Piezoaktor handelt.

13. Gerät (100) nach einem der Ansprüche 10 bis 12,
wobei das Gerät (100) als Mikropumpe ausgestaltet ist.

14. Verfahren zur Ansteuerung einer Last (2) mit einem Ansteuersignal (VPIEZO), wobei eine Wechselspannung (VOUT), die frei von einer negativen Amplitude ist, erzeugt wird,
wobei eine Gleichspannung (V1) erzeugt wird,
wobei ein erster Anschluss (51) eines Kondensators (5) mit der Wechselspannung (VOUT) beaufschlagt wird, dadurch charakterisiert, dass ein zweiter Anschluss (52) des Kondensators (5) in Abhängigkeit von einer an einem Signalausgang (25) anliegenden Spannung mit der Gleichspannung (V1) beaufschlagt wird,
wobei der zweite Anschluss (52) mit der Gleichspannung (V1) beaufschlagt wird, wenn die an dem Signalausgang (25) anliegende Spannung größer oder gleich der Gleichspannung (V1) ist,
wobei das Ansteuersignal (VPIEZO) ein Wechselspannungssignal mit einer positiven Amplitude und einer negativen Amplitude ist,
wobei ein Betrag der positiven Amplitude des Ansteuersignals (VPIEZO) abhängig von dem Betrag der Gleichspannung (V1) der Gleichspannungsquelle (4) ist, und wobei ein Betrag der negativen Amplitude des Ansteuersignals (VPIEZO) abhängig ist von einem Betrag einer Differenz zwischen einem Betrag einer positiven Amplitude der Wechselspannung (VOUT) der Wechselspannungsquelle (3) und dem Betrag der Gleichspannung (V1) der Gleichspannungsquelle (4).

## Claims

1. Apparatus (1) for driving a load (2) with a drive signal (VPIEZO), the apparatus (1) comprising an AC voltage source (3), a DC voltage source (4), a capacitor (5) and a control apparatus (6),
wherein the AC voltage source (3) is configured to output an AC voltage (VOUT),
wherein the DC voltage source (4) is configured to output an DC voltage (V1) with a predeterminable magnitude,
wherein the capacitor (5) comprises a first terminal (51) and a second terminal (52),
wherein the AC voltage source (3) is connected to the first terminal (51),
wherein the AC voltage source (3) is configured such that the AC voltage (VOUT) that is output is free of a negative amplitude,
wherein a signal output (25) is connected to the second terminal (52),
**characterized in that**
the control apparatus (6) is configured to control depending on a voltage present at the signal output (25), a connection between the DC voltage source (4) and the second terminal (52),
wherein the control apparatus (6) is configured to connect the DC voltage source (4) to the second terminal (52) if the voltage present at the signal output (25) is larger than or equal to the DC voltage (V1) of the DC voltage source (4),
wherein the drive signal (VPIEZO) is an AC voltage signal with a positive amplitude and a negative amplitude,
wherein a magnitude of the positive amplitude of the drive signal (VPIEZO) depends on a magnitude of a DC voltage (V1) of the DC voltage source (4) and
wherein a magnitude of the negative amplitude of the drive signal (VPIEZO) depends on a magnitude of a difference between a magnitude of a positive amplitude of the AC voltage (VOUT) of the AC voltage source (3) and the magnitude of the DC voltage (V1) of the DC voltage source (4).

2. Apparatus (1) according to claim 1,
wherein the magnitude of the DC voltage (V1) of the DC voltage source (4) is smaller than a magnitude of a positive amplitude of the AC voltage (VOUT) of the AC voltage source (3).

3. Apparatus (1) according to claim 1 or 2,
wherein the AC voltage source (3) comprises a controllable current source (8), wherein the current source (8) is configured to generate an AC current, and wherein the current source (8) is connected to the first terminal (51) of the capacitor (5).

4. Apparatus (1) according to claim 3,
wherein the current source (8) comprises at least two current regulating circuits (81).

5. Apparatus (1) according to claim 3 or 4,
wherein the AC voltage source (3) comprises a DC voltage converter (7), wherein the DC voltage converter (7) is configured to, based on a DC voltage (VIN), generate a drive voltage (VBST), and
wherein the drive voltage (VBST) generated by the step-up converter (7) is supplied to the current source (8).

6. Apparatus (1) according to any one of claims 1 to 5,
wherein the AC voltage source (3) is configured such that the AC voltage (VOUT) that is output comprises a positive amplitude and an amplitude with 0 volts.

7. Apparatus (1) according to any one of claims 1 to 6,
wherein the load (2) is connected to ground.

8. Apparatus (1) according to any one of claims 1 to 7,
wherein the control apparatus (6) comprises at least one rectifier.

9. Apparatus (1) according to any one of claims 1 to 8,
wherein the control apparatus (6) comprises at least one diode which is connected on the cathode side to the DC voltage source (4) and on the anode side to the signal output (25).

10. Device (100) having at least a load (2) and an apparatus (1) according to any one of the preceding claims.

11. Device (100) according to claim 10,
wherein the apparatus (1) is configured according to any one of claims 2 to 9.

12. Device (100) according to claim 10 or 11,
wherein the load (2) is a piezo actuator.

13. Device (100) according to any one of claims 10 to 12,
wherein the device (100) is configured as a micropump.

14. Method for driving a load (2) with a drive signal (VPIEZO),
wherein an AC voltage (VOUT) that is free of a negative amplitude is generated, wherein a DC voltage (V1) is generated,
wherein a first terminal (51) of a capacitor (5) is provided with the AC voltage (VOUT),
**characterized in that** a second terminal (52) of the capacitor (5) is provided with the DC voltage (V1) depending on a voltage present at a signal output (25), wherein the second terminal (52) is provided with the DC voltage (V1) if the voltage present at the signal output (52) is larger than or equal to the DC voltage (V1),
wherein the drive signal (VPIEZO) is an AC voltage signal with a positive amplitude and a negative amplitude,
wherein a magnitude of the positive amplitude of the drive signal (VPIEZO) depends on the magnitude of the DC voltage (V1) of the DC voltage source (4), and
wherein a magnitude of the negative amplitude of the drive signal (VPIEZO) depends on a magnitude of a difference between a magnitude of a positive amplitude of the AC voltage (VOUT) of the AC voltage source (3) and the magnitude of the DC voltage (V1) of the DC voltage source (4).

## Revendications

1. Dispositif (1) pour commander une charge (2) par un signal de commande (VPIEZO), dans lequel le dispositif (1) présente une source de tension alternative (3), une source de tension continue (4), un condensateur (5) et un dispositif de commande (6),
dans lequel la source de tension alternative (3) est conçue de manière à sortir une tension alternative (VOUT),
dans lequel la source de tension continue (4) est conçue de manière à sortir une tension continue (V1) selon une quantité pouvant être prédéterminée,
dans lequel le condensateur (5) présente une première borne (51) et une deuxième borne (52),
dans lequel la source de tension alternative (3) est connectée à la première borne (51),
dans lequel la source de tension alternative (3) est conçue de sorte que la tension alternative (VOUT) sortie soit exempte d'une amplitude négative,
dans lequel une sortie de signal (25) est connectée à la deuxième borne (52),
**caractérisé par le fait que**
le dispositif de commande (6) est conçu pour commander, en fonction d'une tension présente à la sortie de signal (25), une connexion de la source de tension continue (4) à la deuxième borne (52),
dans lequel le dispositif de commande (6) est conçu pour connecter la source de tension continue (4) à la deuxième borne (52) lorsque la tension présente à la sortie de signal (25) est supérieure ou égale à la tension continue (V1) de la source de tension continue (4),
dans lequel le signal de commande (VPIEZO) est un signal de tension alternative avec une amplitude positive et une amplitude négative,
dans lequel une quantité de l'amplitude positive du signal de commande (VPIEZO) dépend de la quantité de tension continue (V1) de la source de tension continue (4), et
dans lequel une quantité de l'amplitude négative du signal de commande (VPIEZO) dépend d'une quantité d'une différence entre une quantité d'une amplitude positive de la tension alternative (VOUT) de la source de tension alternative (3) et la quantité de la tension continue (V1) de la source de tension continue (4).

2. Dispositif (1) selon la revendication 1,
dans lequel la quantité de la tension continue (V1) de la source de tension continue (4) est inférieure à une quantité d'une amplitude positive de la tension alternative (VOUT) de la source de tension alternative (3).

3. Dispositif (1) selon la revendication 1 ou 2,
dans lequel la source de tension alternative (3) présente une source de courant pouvant être commandée (8), dans lequel la source de courant (8) est conçue pour générer un courant alternatif, et
dans lequel la source de courant (8) est connectée à la première borne (51) du condensateur (5).

4. Dispositif (1) selon la revendication 3,
dans lequel la source de courant (8) présente au moins deux circuits de régulation de courant (81).

5. Dispositif (1) selon la revendication 3 ou 4,
dans lequel la source de tension alternative (3) présente un convertisseur de tension continue (7),
dans lequel le convertisseur de tension continue (7) est conçu pour générer, partant d'une tension continue (VIN), une tension de commande (VBST), et
dans lequel la tension de commande (VBST) générée par le convertisseur vers le haut (7) est alimentée vers la source de courant (8).

6. Dispositif (1) selon l'une des revendications 1 à 5,
dans lequel la source de tension alternative (3) est conçue de sorte que la tension alternative (VOUT) sortie présente une amplitude positive et une amplitude de 0 volt.

7. Dispositif (1) selon l'une des revendications 1 à 6,
dans lequel la charge (2) est reliée à la terre.

8. Dispositif (1) selon l'une des revendications 1 à 7,
dans lequel le dispositif de commande (6) présente au moins un redresseur.

9. Dispositif (1) selon l'une des revendications 1 à 8,
dans lequel le dispositif de commande (6) présente au moins une diode qui est connectée, du côté de la cathode, à la source de tension continue (4) et, du côté de l'anode, à la sortie de signal (25).

10. Appareil (100) avec au moins une charge (2) et un dispositif (1) selon l'une des revendications précédentes.

11. Appareil (100) selon la revendication 10,
dans lequel l'appareil (1) est conçu selon l'une des revendications 2 à 9.

12. Appareil (100) selon la revendication 10 ou 11,
dans lequel il s'agit, pour la charge (2), d'un actionneur piézoélectrique.

13. Appareil (100) selon l'une des revendications 10 à 12,
dans lequel l'appareil (100) est conçu comme une micro-pompe.

14. Procédé de commande d'une charge (2) par un signal de commande (VPIEZO),
dans lequel est générée une tension alternative (VOUT) qui est exempte d'une amplitude négative,
dans lequel est générée une tension continue (V1),
dans lequel à une première borne (51) d'un condensateur (5) est appliquée une tension alternative (VOUT),
**caractérisé par le fait que**
à une deuxième borne (52) du condensateur (5) est appliquée, en fonction de la tension présente à une sortie de signal (25), la tension continue (V1),
dans lequel à la deuxième borne (52) est appliquée la tension continue (V1) lorsque la tension présente à la sortie de signal (25) est supérieure ou égale à la tension continue (V1),
dans lequel le signal de commande (VPIEZO) est un signal de tension alternative avec une amplitude positive et une amplitude négative,
dans lequel une quantité de l'amplitude positive du signal de commande (VPIEZO) dépend de la quantité de la tension continue (V1) de la source de tension continue (4), et
dans lequel une quantité de l'amplitude négative du signal de commande (VPIEZO) dépend d'une quantité d'une différence entre une quantité d'une amplitude positive de la tension alternative (VOUT) de la source de tension alternative (3) et la quantité de la tension continue (V1) de la source de tension continue (4).
